# EUROPÄISCHE PATENTANMELDUNG

(11) **EP 4 821 850 A1**
(43) Veröffentlichungstag der Anmeldung: **14.10.2026**
(21) Anmeldenummer: 25169546.6
(22) Anmeldetag: 09.04.2025
(51) Int. Cl.: B65G 47/14

(54) **VORRICHTUNG ZUM ENTNEHMEN VON DRÄHTEN AUS EINEM DRAHTBÜNDEL**

(71) Anmelder: Ideal-Werk C. & E. Jungeblodt GmbH & Co.KG, 59557 Lippstadt (DE)
(72) Erfinder: Hils, Reinhold, 33129 Delbrück (DE)
(74) Vertreter: Fritz Patent- und Rechtsanwälte PartmbB

(57) **Zusammenfassung**

Die Erfindung betrifft eine Vorrichtung (V) zur Entnahme von Drähten aus einem Drahtbündel (B) und Ausrichten der Drähte,
- mit einer Ablage für das Drahtbündel (B),
- mit einer Führung (82, 91) zum Ausrichten der aus dem Drahtbündel (B) entnommenen Drähte,
- mit einem Entnahmerad (11) zum Entnehmen eines Drahtes (D) aus dem Drahtbündel (B) und zum Übergeben des entnommenen Drahtes (D) an die Führung (82, 91), wobei das Entnahmerad (11) drehbar gelagert ist,
- mit einem Antrieb zum Antreiben der Drehung des Entnahmerades (11),
- wobei das Entnahmerad (11) eine Kerbe (112) zum Mitnehmen eines Drahtes (D) aufweist, in die ein Draht (D) des Drahtbündels (B) bei einer Drehung des Entnahmerades (11) aufgenommen wird und von der dieser Draht (D) mitgenommen wird,
- wobei die Vorrichtung (V) Transporträder (12) aufweist, die koaxial und in axialer Richtung mit Abstand zu dem Entnahmerad (11) von einem Antrieb drehbar angeordnet sind, die je eine Kerbe zum Mitnehmen des Drahts (D) aufweisen, der in der Mitnehmerkerbe des Entnahmerades aufgenommen ist und
- wobei die Vorrichtung (V) Elemente (13) zum Verhindern der Aufnahme eines Drahtes (D) in die Mitnehmerkerben der Transporträder (12) aufweist, durch die verhindert wird, dass ein Draht des Drahtbündels (B) in die Mitnehmerkerbe der Transporträder (12) aufgenommen wird, der nicht in der Mitnehmerkerbe (112) des Entnahmerades (11) aufgenommen ist.

## Beschreibung

Die vorliegende Erfindung betrifft eine Vorrichtung zur Entnahme von Drähten aus einem Drahtbündel und Ausrichten der Drähte,
a. mit einer Ablage für das Drahtbündel,
b. mit einer Führung zum Ausrichten der aus dem Drahtbündel entnommenen Drähte,
c. mit einem ersten Entnahmerad zum Entnehmen eines Drahtes aus dem Drahtbündel und zum Übergeben des entnommenen Drahtes an die Führung, wobei das Entnahmerad drehbar gelagert ist, und
d. mit einem Antrieb zum Antreiben der Drehung des Entnahmerades,
e. wobei das Entnahmerad eine Kerbe zum Mitnehmen eines Drahts aufweist, in die ein Draht des Drahtbündels bei einer Drehung des Entnahmerades aufgenommen wird und von der dieser Draht mitgenommen wird.

Für die Fertigung von Gittermatten müssen Drähte sortiert, vereinzelt und zum einen als Längsdrähte und zum anderen als Querdrähte einer Schweißmaschine zugeführt werden. Die Drähte werden gebündelt angeliefert. Aus diesen Drahtbündeln müssen die Drähte entnommen und vereinzelt werden, bevor sie in der Schweißmaschine verarbeitet werden können.

Die Entnahme eines einzelnen Drahtes aus einem ungeordneten und frei liegenden Drahtbündel bezeichnet man auch als Sortierung. Nach der Entnahme eines Drahtes aus dem Drahtbündel erfolgt die Zuführung des entnommenen Drahtes in einen Bereich zwischen zwei Führungselementen, so dass eine geordnete, ausgerichtete Lage von Drähten erreicht wird, die eine Vereinzelung erlaubt. Besonders für sehr lange und dünne Drähte, die häufig miteinander verschlungen im Drahtbündel liegen, führt dieser Prozess der Sortierung zu Fehlern.

Neben anderen Ansätzen zur Sortierung ist die Verwendung eines Sortier- oder Entnahmerades üblich. Dieses Entnahmerad ist meist mittig in Bezug zur Drahtlänge angeordnet und nimmt über eine Mitnehmerkerbe einen Draht aus dem Drahtbündel. Es folgt eine kreisförmige Bewegung der von der Mitnehmerkerbe erfassten Drahtmitte, welche zunächst einen starken vertikalen Anteil hat. Die Drahtenden des vom Entnahmerad mitgenommenen Drahtes können dabei zunächst zwischen den anderen Drähten des Drahtbündels liegen. Diese können unter anderen Drähten des Bündels liegen, so dass sie nicht frei liegen. Erst mit zunehmender Höhe der Drahtmitte des zu entnehmenden Drahtes setzt sich die Vertikalbewegung zu den Drahtenden fort. Es wird durch die Mitnehmerkerbe des Entnahmerades immer mehr des mitgenommenen Drahtes mitgezogen. Dabei wird der mitgenommene Draht auf Biegung beansprucht.

Durch die Mitnahme des Drahtes mit Hilfe des Entnahmerads nur in der Drahtmitte lässt sich eine Biegespannung im Draht nicht vermeiden. Die Kraft, die zum Entnehmen des mitgenommenen Drahtes aus dem Drahtbund notwendig ist, erzeugt die Kraftkomponente nach unten zur Bildung des Momentes im Draht. Eine zunehmende Drahtlänge und ein abnehmender Drahtdurchmesser wirken sich im Ergebnis auf die Spannungsverhältnisse im Draht aus, so dass es insbesondere bei langen und/oder dünnen Drähten zu einer plastischen Verformung des Drahtes kommen kann.

Zur Reduzierung des Problems der plastischen Verformung muss der Hebel der Kraft auf den Draht in der Mitnehmerkerbe deutlich reduziert werden. Die bei der Betrachtung der Biegung günstigste Lösung würde die Aufwärtsbewegung des vom Entnahmerad mitgenommenen Drahtes auf der ganzen Drahtlänge unterstützen.

Dieses könnte durch eine Erhöhung der Anzahl der Entnahmeräder erreicht werden. Eine Verwendung von zwei oder mehr Entnahmerädern ist nicht ohne weiteres möglich, da nicht sichergestellt ist, dass durch die Entnahmeräder der gleiche Draht aus dem Drahtbündel entnommen wird. Es ist nicht sichergestellt, dass durch die Mitnehmerkerben der Entnahmeräder der gleiche Draht zur Mitnahme ausgewählt wird.

Hier setzt die vorliegende Erfindung an.

Der Erfindung liegt daher das ungelöste Problem zu Grunde, die Kraft auf den aus dem Drahtbündel zu entnehmenden Draht zu reduzieren, um eine plastische Verformung des Drahtes zu reduzieren oder bestenfalls sogar zu verhindern.

Dieses Problem wir erfindungsgemäß dadurch gelöst, dass
a. die Vorrichtung Transporträder aufweist, die koaxial und mit Abstand zu dem Entnahmerad angeordnet sind, die je eine Kerbe zum Mitnehmen des Drahts aufweisen, der in der Mitnehmerkerbe des Entnahmerades aufgenommen ist und
b. dass die Vorrichtung Elemente zum Verhindern der Aufnahme eines Drahtes in die Mitnehmerkerben der Transporträder aufweist, durch die verhindert wird, dass ein Draht des Drahtbündels in die Mitnehmerkerbe aufgenommen wird, der nicht in der Mitnehmerkerbe des Entnahmerades aufgenommen ist.

Zum Entnehmen eines Drahts aus einem Drahtbündel und zum Ausrichten des entnommenen Drahtes mit einer Vorrichtung kann so vorgegangen werden: Mittels einer Mitnehmerkerbe des sich drehenden Entnahmerades wird ein Draht aus dem Drahtbündel erfasst und die erfasste Stelle des Drahtes wird durch das Entnahmerad mitgenommen und aus oder von dem Drahtbündel entfernt. Dabei wird der entnommene Draht über die Anlagefläche oder Anlagekante der Elemente zum Verhindern der Aufnahme eines Drahtes in die Mitnehmerkerben der Transporträder bis zu deren oberen Enden bewegt. Ist das obere Ende erreicht, wird dann der entnommene Draht von den Mitnehmerkerben der Transporträder erfasst und zu der Führung transportiert. An deren Beginn wird der entnommene Draht aus den Mitnehmerkerben des Entnahmerades und der Transporträder herausgehoben und in die Führung bewegt.

Um kurze Entfernungen zwischen der Widerstandskraft gegen Herauslösen der Drähte aus dem Drahtbund und der Aufwärtskraft des Entnahmerades zu erreichen, ist eine große Anzahl an Transporträdern über die gesamte Drahtlänge notwendig. Das Entnahmerad mit der Mitnehmerkerbe dient zur Auswahl des Drahtes, welcher als nächstes aus dem Drahtbund herausgelöst werden soll. Die Aufwärtsbewegung des von der Mitnehmerkerbe des Entnahmerades erfassten Bereichs des Drahtes setzt sich immer weiter in andere Bereiche des Drahtes fort, die angehoben werden. Die so angehobenen Bereiche des mitgenommenen Drahtes können zur weiteren Identifikation des Drahtes benutzt werden, um den richtigen Draht in seiner weiteren Aufwärtsbewegung durch die Transporträder zu unterstützen. Diese weiteren Unterstützungen des Drahtes wirken also erst in einer Höhe, in der sich ausschließlich der vom Sortierrad mitgenommene Draht befinden kann. Das wird durch die Elemente zum Verhindern der Aufnahme eines Drahtes in die Mitnehmerkerben der Transporträder erreicht, die die Aufnahme eines beliebigen Drahtes, der nicht durch das Entnahmerad herausgehoben wurde, verhindern.

Eine Besonderheit der Erfindung besteht darin, je ein Element zum Verhindern vor unteren Bereichen jedes Transportrads bereitzustellen, das die Mitnahme eines nicht durch das Entnahmerad aus dem Drahtbund herausgehobenen Drahtes verhindert. Nur der vom Entnahmerad angehobene Draht kann von den Transporträdern erfasst und mitgenommen werden.

Vorzugsweise ist das Entnahmerad in der Mitte der Transporträder angeordnet, so dass mit dem Entnahmerad die Mitte des zu entnehmenden Drahtes erfasst werden kann. Grundsätzlich kann das Entnahmerad aber auch an einem Ende der nebeneinander angeordneten Transporträder vorgesehen sein.

Vorzugsweise können die Transporträder mittels des gleichen Antriebes angetrieben werden wie das Entnahmerad.

Es ist möglich, dass zwischen dem Antrieb und dem Entnahmerad und/oder zwischen dem Antrieb und einem oder mehreren oder allen Transporträdern ein Getriebe angeordnet ist, so dass die Räder zwar vom gleichen Antrieb aber mit unterschiedlichen Geschwindigkeiten angetrieben werden können.

Eine besonders einfache Übertragung einer Drehbewegung vom Anrieb auf das Entnahmerad und die Transporträder ist möglich, wenn das Entnahmerad und die Transporträder drehfest auf einer Welle angeordnet sind. Diese Welle kann dann unmittelbar mit einer Welle des Antriebs gekoppelt sein.

Es hat sich gezeigt, dass es von Vorteil ist, wenn die Transporträder eine größere Anzahl von Mitnehmerkerben aufweisen als das Entnahmerad.

Vorzugsweise ist jedem der Transporträder wenigstens eines der Elemente zum Verhindern der Aufnahme eines Drahtes in die Mitnehmerkerben der Transporträder zugeordnet.

Die Elemente zum Verhindern einer erfindungsgemäßen Entnahme- und Ausrichtvorrichtung können
a. von einer Drehachse der Transporträder aus betrachtet in Richtung der Ablage über die Transporträder und
b. von der Ablage aus betrachtet über eine durch die Ablage definierte Ablageebene für das Drahtbündel
hinausragen.

Die Elemente zum Verhindern können eine kreisbogenförmig gebogene Anlagefläche oder Anlagekante aufweisen, wobei die Anlagefläche oder Anlagekante jedes Elements auf einem Kreis um die Drehachse des Transportrades liegt, dem das Element zugeordnet ist.

Ein Winkel zwischen der Ablageebene und einem oberen Ende der Anlagefläche oder Anlagekante jedes Elements kann einstellbar sein. So kann zum Beispiel in Abhängigkeit von der Drahtlänge, des Drahtdurchmessers und der Größe des Drahtbündels eingestellt werden, wie weit ein Draht mittels des Entnahmerades aus dem Bündel herausgehoben sein muss, bevor die Transporträder den herausgehobenen Draht bei seiner Bewegung unterstützen können. Der Winkel kann zum Beispiel bei kurzen und dünnen Drähten kleiner sein als bei langen und dicken Drähten. Ebenso kann er bei kleinen Drahtbündeln kleiner sein als bei großen Drahtbündeln. Es ist möglich, dass der Winkel zwischen der Ablageebene und dem oberen Ende der Anlagefläche oder Anlagekante für jedes Element individuell einstellbar ist. So kann es zum Beispiel sinnvoll sein, den Winkel bei Transporträdern bzw. Elementen, die weiter von dem Entnahmerad entfernt sind als andere, anders zu wählen, insbesondere kleiner zu wählen als bei Transporträdern bzw. Elementen, die eine größere Nähe zum Entnahmerad haben.

Jedes der Elemente zum Verhindern kann verschiebbar an einem Halter befestigt sein, wodurch insbesondere der Winkel zwischen der Ablageebene und einem oberen Ende der Anlagefläche oder Anlagekante jedes Elements eingestellt werden kann.

Die Führung einer erfindungsgemäßen Entnahme- und Ausrichtvorrichtung kann wenigstens ein unteres Führungselement und wenigstens ein oberes Führungselement aufweisen, wobei wenigstens eines der oberen Führungselemente und wenigstens eines der unteren Führungselemente einander zugeordnet sein können und einen Spalt bilden, in den die aus dem Drahtbündel entnommenen Drähte mittels des Entnahmerades und der Transporträder gefördert werden können. Die Breite des Spaltes kann einstellbar sein, zum Beispiel um die Führung auf unterschiedlich dicke Drähte einzustellen. Zum Einstellen der Breite des Spaltes kann das wenigstens eine obere Führungselement verschiebbar gelagert sein.

Weitere Merkmale und Vorteile von Ausführungsbeispielen der Erfindung werden unter Bezugnahme auf die Zeichnungen nachfolgend beschrieben. Dabei werden für gleiche oder ähnliche Teile und für Teile mit gleichen oder ähnlichen Funktionen dieselben Bezugszeichen verwendet. Es zeigen in schematischer, vereinfachter Darstellung:

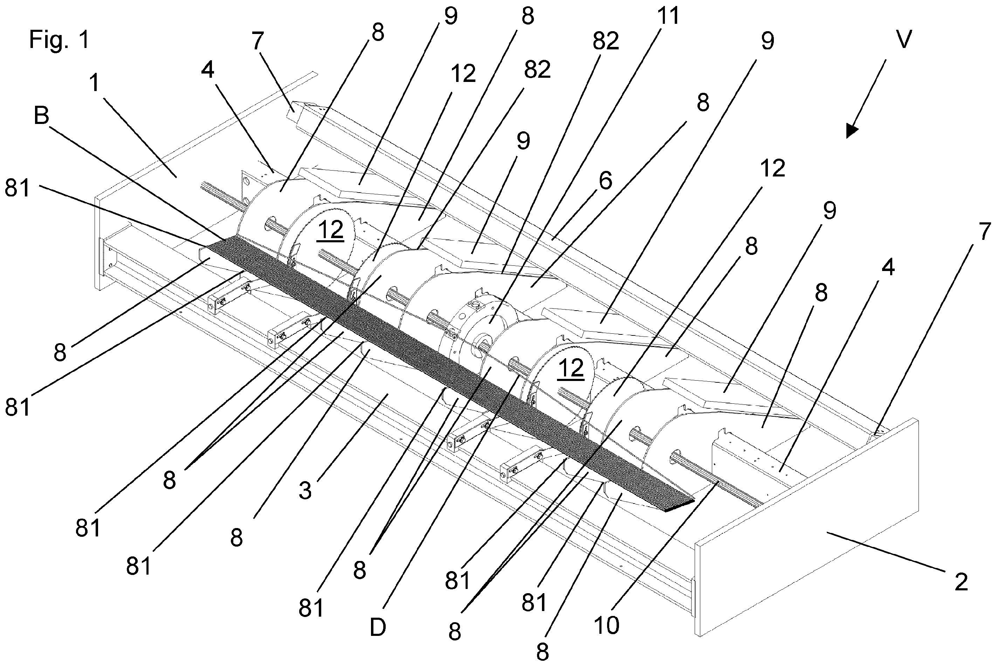

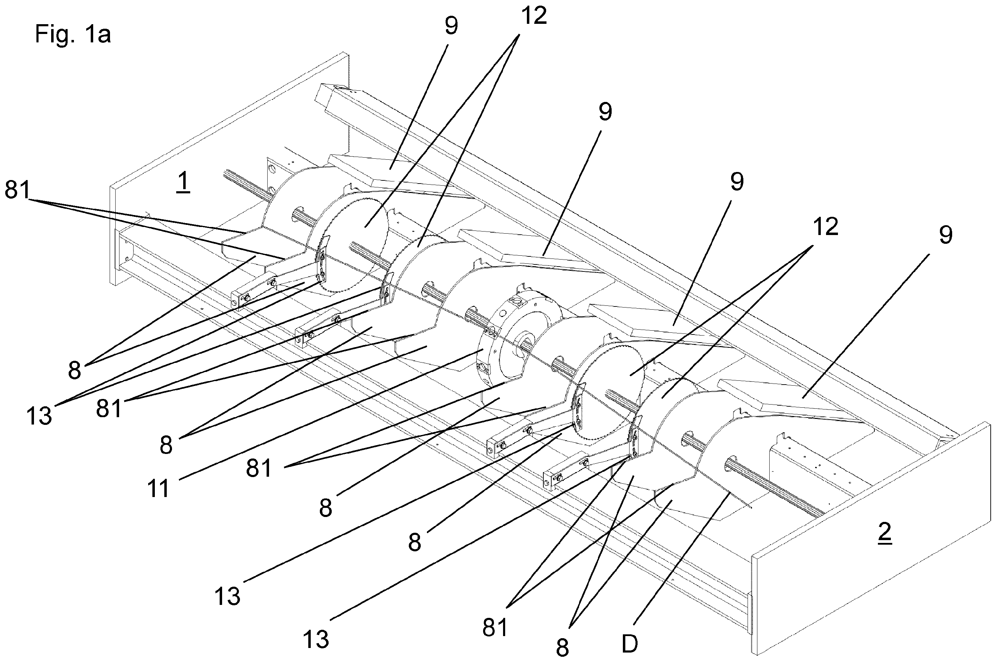

- Fig. 1: eine perspektivische Ansicht wichtiger Teile einer erfindungsgemäßen Vorrichtung, eines auf einer Ablage der Vorrichtung abgelegten Drahtbündels und eines aus dem Drahtbündel entnommenen Drahtes,
- Fig. 1a: die Darstellung aus Fig. 1, jedoch ohne Drahtbündel,

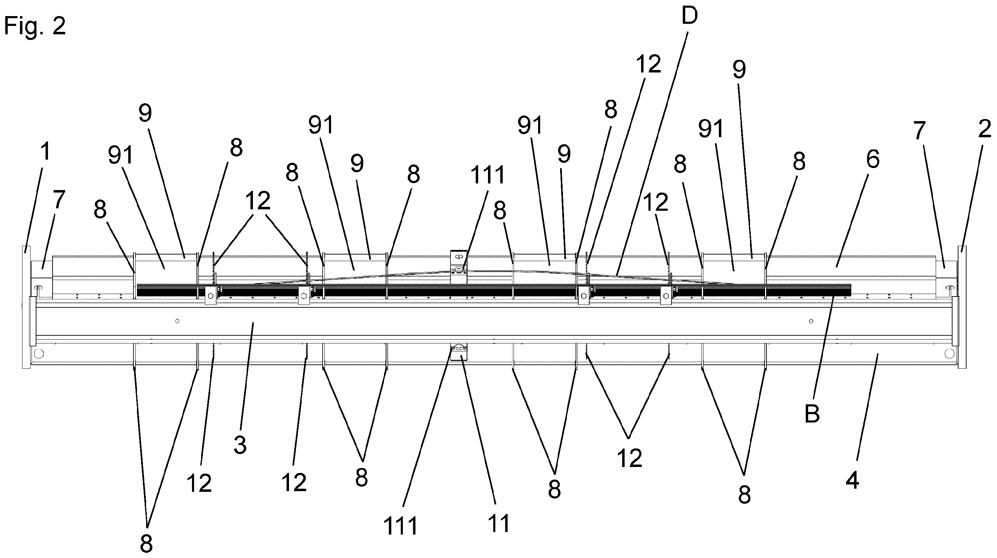

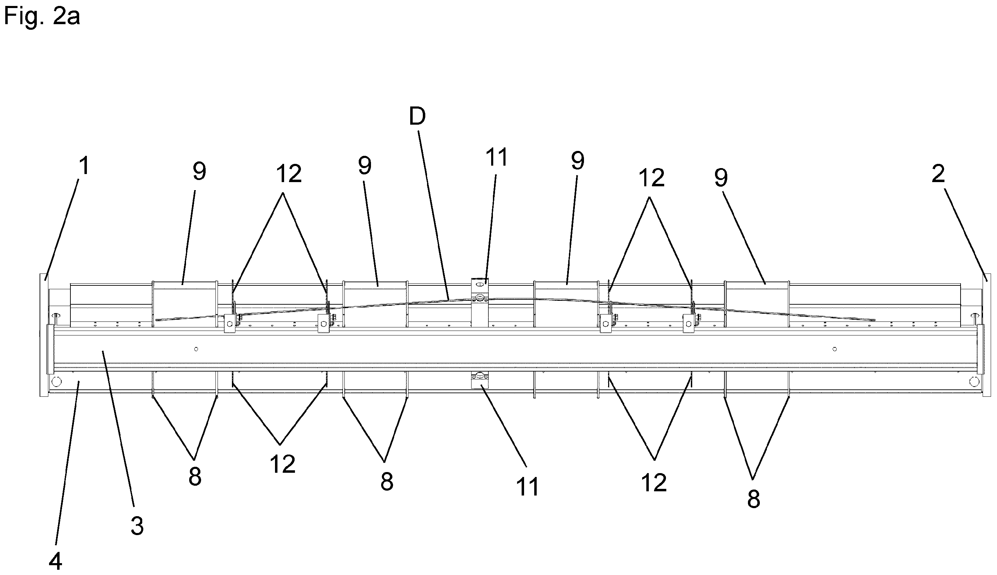

- Fig. 2: eine Ansicht wichtiger Teile der Vorrichtung von vorne mit Drahtbündel und aus dem Drahtbündel entnommenen Draht,
- Fig. 2a: die Darstellung aus Fig. 2, jedoch ohne Drahtbündel,

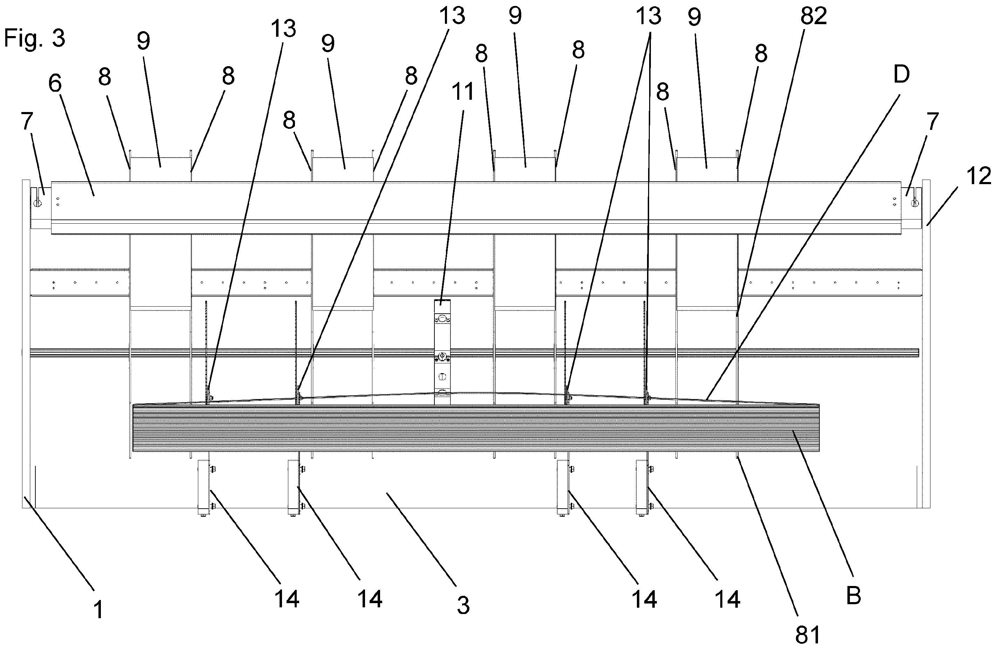

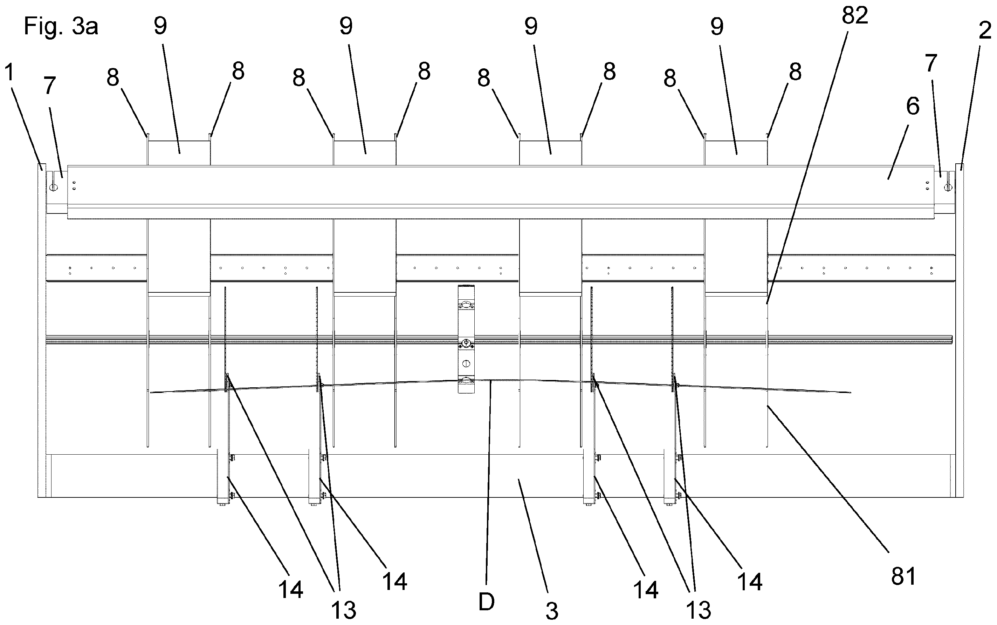

- Fig. 3: eine Ansicht wichtiger Teile der Vorrichtung von oben mit Drahtbündel und aus dem Drahtbündel entnommenen Draht,
- Fig. 3a: die Darstellung aus Fig. 3, jedoch ohne Drahtbündel,

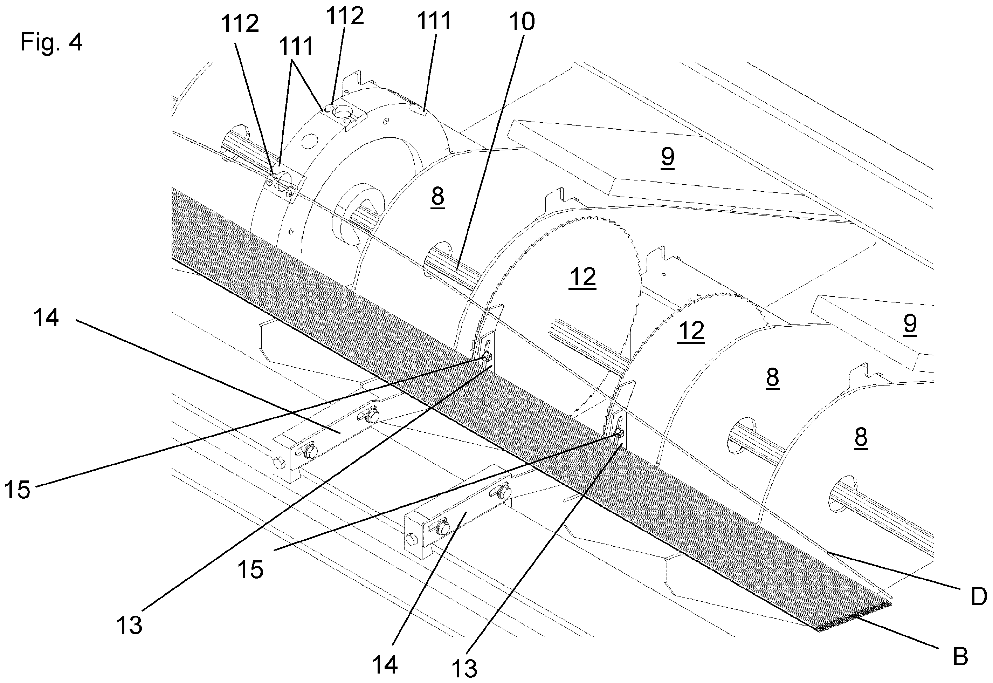

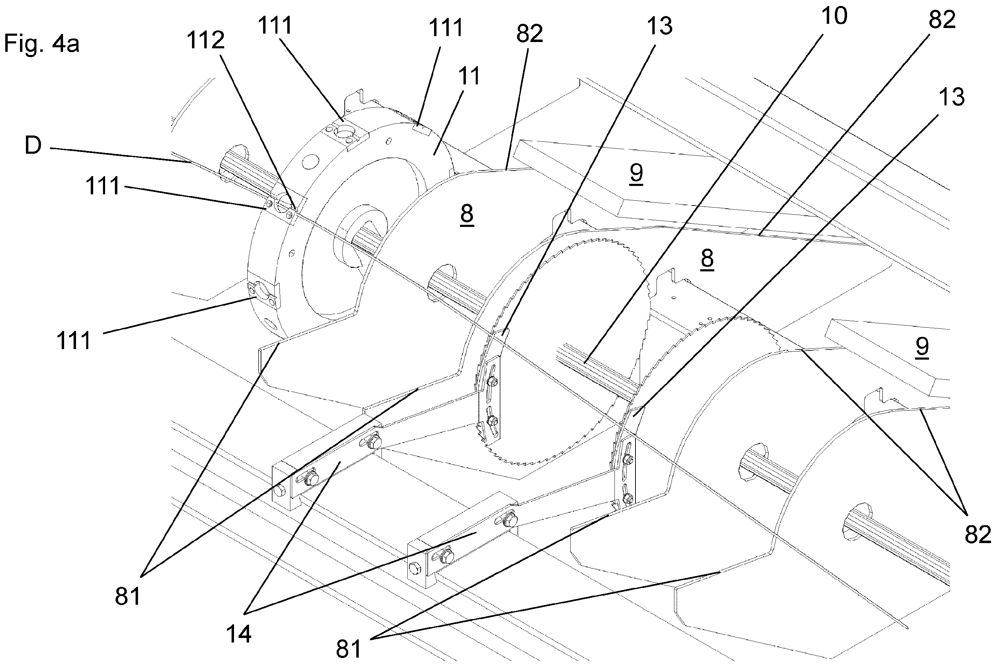

- Fig. 4: einen Ausschnitt aus Fig. 1,
- Fig. 4a: einen Ausschnitt aus Fig. 1a

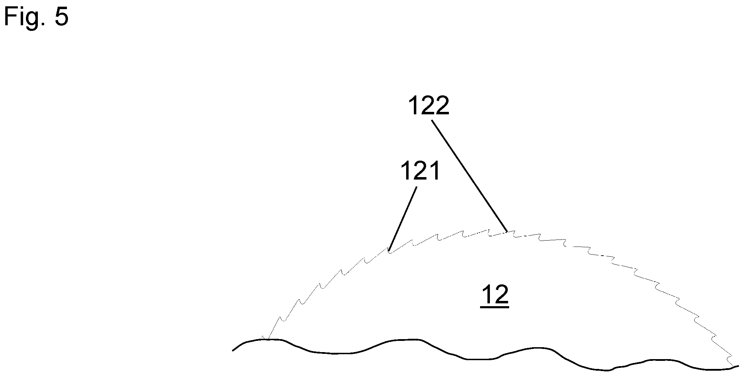

- Fig 5: einen Ausschnitt aus einer Seitenansicht eines Transportrads und

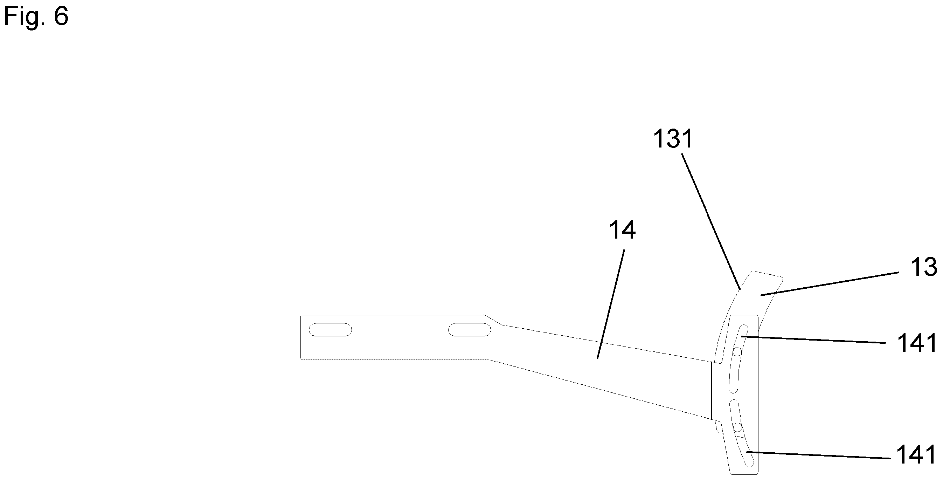

- Fig. 6: eine Seitenansicht eines Elementes zum Verhindern der Aufnahme des Drahts in Mitnehmerkerben der Transporträder.

Es ist nicht notwendig, dass eine erfindungsgemäße Vorrichtung alle nachfolgend beschriebenen Merkmale aufweist. Es ist auch möglich, dass eine erfindungsgemäße Vorrichtung nur einzelne Merkmale des nachfolgend beschriebenen Ausführungsbeispiels aufweist.

Die erfindungsgemäße Vorrichtung V weist einen Rahmen mit zwei seitlichen Rahmenteilen 1, 2, einem vorderen Rahmenteil 3, einem hinteren Rahmenteil 4 und vorderen Verbindungsteilen 5 auf. Das vordere Rahmenteil 3 ist zwischen den beiden seitlichen Rahmenteilen 1, 2 eingesetzt und über die vorderen Verbindungsteile 5 mit den seitlichen Rahmenteilen 1, 2 verbunden. Das hintere Rahmenteil 4 ist zwischen den beiden seitlichen Rahmenteilen 1, 2 eingesetzt und mit den seitlichen Rahmenteilen 1, 2 verbunden.

Zwischen den beiden seitlichen Rahmenteilen 1, 2 ist auch ein Träger 6 eingesetzt, der über hintere Verbindungsteile 7 mit den seitlichen Rahmenteilen 1, 2 verbunden ist.

An dem hinteren Rahmenteil 4 sind Blechstücke 8 befestigt. Diese Blechstücke 8 haben Löcher, die dem Querschnitt des hinteren Rahmenteils entsprechen. Das hintere Rahmenteil 4 durchgreift diese Löcher. Die Blechstücke 8 sitzen auf dem hinteren Rahmenteil 4 und sind so mit dem Rahmen der Vorrichtung verbunden.

Die Blechstücke 8 haben jeweils eine erste Fläche 81, auf denen ein Drahtbündel B abgelegt werden kann. Die ersten Flächen 81 bilden zusammen eine Ablage der Vorrichtung V für das Drahtbündel B.

Die Blechstücke 8 haben jeweils auch eine zweite Fläche 82. Diese bilden untere Führungsflächen einer Führung 82, 91 für aus dem Drahtbündel B entnommene Drähte. Diese Drähte werden mittels der Führungen ausgerichtet.

Die Führung 82, 91 wird durch Flächen 91 von oberen Führungselementen 9 komplettiert, die an einer Unterseite des Trägers 6 befestigt sind.

Die Vorrichtung V weist ferner eine Welle 10 auf, die mit einem Ende an einem der beiden seitlichen Rahmenteile 1, 2 gelagert ist und durch das andere seitliche Rahmenteil 1, 2 hindurchgeführt ist. Ein durch das andere seitliche Rahmenteil 1, 2 hindurchgeführtes Ende der Welle 10 ist mit einem nicht dargestellten Antrieb der Vorrichtung V verbunden. Der Antrieb dreht die Welle 10 in die Richtung des Pfeiles P.

Auf der Welle 10 ist in etwa mittig zwischen den seitlichen Rahmenteilen 1, 2 ein Entnahmerad 11 drehfest angebracht. Im Abstand zu dem Entnahmerad 11 in Richtung zu den seitlichen Rahmenteilen 1, 2 versetzt sind auf beiden Seiten des Entnahmerades 11 je zwei Transporträder 12 drehfest auf der Welle 10 angeordnet.

Das Entnahmerad 11 weist im Winkel von 45° zueinander versetzt auf seiner Außenseite Einsätze 111 auf. Jeder diese Einsätze 111 des Entnahmerades 11 hat eine Kerbe, die Mitnehmerkerbe 112 genannt wird. Diese Mitnehmerkerben 112 sind dazu vorgesehen, einen Draht D auf dem Drahtbündel B zu entnehmen und zu vereinzeln. Die Einsätze 111 können von dem übrigen Entnahmerad 11 gelöst werden und gegen andere Einsätze getauscht werden, deren Mitnehmerkerben 112 andere Abmessungen und/oder eine andere Form haben und die für andere als die in den Figuren dargestellten Drähte besser geeignet sind.

Die Anordnung der Mitnehmerkerben 112 im Winkel von 45° zueinander macht es möglich, dass das Entnahmerad 11 bei einer Umdrehung bis zu acht Drähte aus dem Bündel B entnimmt, vereinzelt und in Richtung der Führung befördert, durch die die Drähte ausgerichtet werden.

Die Transporträder 12 weisen einen Rand auf, der eine Zahnung in Form von Sägezähnen hat, wobei jeder Sägezahn eine steile Flanke 121 und eine flache Flanke aufweist. Die steile Flanke 121 eines Zahns und die flache Flanke eines benachbarten Zahns bilden Mitnehmerkerben der Transporträder. Die steilen Flanken 121 der Sägezähne dieser Zahnung sind so ausgerichtet, dass sie einen Draht **D,** der durch die Drehung des Entnahmerades 11 mittels einer der Mitnehmerkerben 112 des Entnahmerades 11 aus dem Drahtbündel B herausgehoben wurde, von der steilen Flanke 121 eines der Zähne des Randes des Transportrads 12 ergriffen und unterstützt wird, so dass der Draht D nicht nur durch das Entnahmerad 11 in der Drehrichtung nach oben befördert wird, sondern auch durch die Transporträder 12. Die Zahnung der Transporträder 12 ist deutlich enger als die Verteilung der acht Mitnehmerkerben 112 des Entnahmerades 11. So kann im Grunde jedes der Transporträder 12 nahezu jederzeit während seiner Drehung einen Draht ergreifen und bei seinem Weg von der Ablage zur Führung unterstützen.

Die erfindungsgemäße Vorrichtung weist ferner Elemente 13 zum Verhindern der Aufnahme des Drahts in Mitnehmerkerben der Transporträder 12 auf. Durch diese wird verhindert, dass ein Draht des Drahtbündel B in eine der Mitnehmerkerben eines Transportrades 12 aufgenommen wird, der nicht schon in einer der Mitnehmerkerben 112 des Entnahmerads 11 aufgenommen ist. Dadurch soll sichergestellt sein, dass nur die Drähte von den Transporträdern 12 erfasst und bewegt werden, die zuvor von dem Entnahmerad 11 aus dem Drahtbündel B entnommen wurden. Jedem der Transporträder 12 ist eines der Elemente 13 zugeordnet und umgekehrt.

Diese Elemente 12 weisen eine zur Welle 10 und damit zu den Transporträdern 13 konzentrisch angeordnete, kreisbogenförmige Anlagefläche 131 auf. Der Radius von der Drehachse der Welle 10 zu dieser Anlagefläche 131 ist etwas größer oder gleich dem Radius von Drehachse bis zu den Spitzen der Zähne der Zahnung des zugeordneten Transportrades 12.

Diese Anlagefläche 131 ragt nach oben über durch die Flächen 81 der Blechstücke 8 gebildete Ablagen hinaus. Von der Ablage bis zum oberen Ende der Anlagefläche 131 deckt die Anlagefläche 131 die Zahnung des zugeordneten Transportrades 12 ab. Ein Draht, der auf der Ablage liegt, kann dadurch nicht von einem der Transporträder 12 erfasst werden. Ein auf der Ablage liegender Draht kann ausschließlich von dem Entnahmerad 11 erfasst werden. Dieses fördert den erfassten Bereich des aus dem abgelegten Bündel entnommenen Drahtes D nach oben, so wie es in den Figuren dargestellt ist. Dabei werden die an den erfassten Bereich des entnommenen Drahtes D angrenzende Bereiche des Drahtes D ebenfalls von der Mitte des Drahtes D ausgehend und sich zu den Enden des Drahtes fortsetzend immer mehr aus dem Bündel B herausgehoben und nach oben transportiert.

Dadurch wird der Draht D nach und nach soweit nach oben transportiert, dass er von der Mitte der Vorrichtung bzw. vom Entnahmerad 11 ausgehend nach und nach über das obere Ende der Anlageflächen 131 der Elemente 13 zum Verhindern der Aufnahme des Drahts D in Mitnehmerkerben der Transporträder 12 gehoben wird. Der Draht D kann dann von einer der Mitnehmerkerben des zugeordneten Transportrades 12 mitgenommen werden. Das Transportrad 12 kann dann den Draht D auf seinem Weg zur Führung unterstützen, so dass der Draht D nicht so stark gebogen wird, wie bei fehlender Unterstützung durch die Transporträder 12. Sobald der Draht über das obere Ende der Anlagefläche eines der Elemente 13 angehoben ist, ist der Draht D so weit von der Ablage bzw. von dem Drahtbündel B entfernt, dass dann keine Gefahr mehr besteht, dass das zugeordnete Transportrad 12 einen anderen Draht erfasst als der, den das Entnahmerad 11 erfasst hat.

Je nach Größe des Drahtbündels, der Dicke der zu vereinzelnden Drähte und/oder der Länge der Drähte, kann die Höhe, um die ein entnommener Draht über die Ablage bzw. das Drahtbündel auf der Ablage nach oben befördert werden muss, damit ein Transportrad 12 nur diesen Draht erfassen kann, größer oder kleiner sein. Es ist daher sinnvoll, die Lage des Endes der Anlageflächen 131 der Elemente 13 zum Verhindern der Aufnahme des Drahts in Mitnehmerkerben der Transporträder 12 einstellen zu können. Daher sind diese Elemente 13 bei der dargestellten erfindungsgemäßen Vorrichtung V einstellbar. Sie sind dazu an Haltern 14 befestigt, die wiederum an dem vorderen Rahmenteil 3 befestigt sind. Die Halter 14 weisen je zwei kreisbogenförmige Langlöcher 141 auf, deren Kreisbogen konzentrisch zur Drehachse der Welle 10 ist. Je eine Schraube 15 ist durch diese Langlöcher 141 geführt und in den Elemente 13 eingeschraubt. Dadurch sind die Elemente 13 an dem Halter 14 befestigt. Löst man die Schrauben 15 ein wenig, kann man die Elemente 13 entlang der Langlöcher verschieben, um das obere Ende der Anlagefläche 131 einzustellen.

Sobald der entnommene und so vereinzelte Draht von der Ablage ausgehend um ca. 110° um die Drehachse der Welle 10 gedreht worden ist, stößt der Draht auf die zweite Fläche 82 der Blechstücke 8. Diese heben den Draht D aus den Mitnehmerkerben des Entnahmerades 11 und der Transporträder 12 heraus. Der Draht bewegt sich dann auf der zweiten Fläche 82 und rollt in die Führung, wodurch er ausgerichtet wird und dann am Ende der Führung zur weiteren Verarbeitung bereitsteht.

## Patentansprüche

1. Vorrichtung (V) zur Entnahme von Drähten aus einem Drahtbündel (B) und Ausrichten der Drähte,
- mit einer Ablage für das Drahtbündel (B),
- mit einer Führung (82, 91) zum Ausrichten der aus dem Drahtbündel (B) entnommenen Drähte,
- mit einem Entnahmerad (11) zum Entnehmen eines Drahtes (D) aus dem Drahtbündel (B) und zum Übergeben des entnommenen Drahtes (D) an die Führung (82, 91), wobei das Entnahmerad (11) drehbar gelagert ist,
- mit einem Antrieb zum Antreiben der Drehung des Entnahmerades (11),
- wobei das Entnahmerad (11) eine Kerbe (112) zum Mitnehmen eines Drahtes (D) aufweist, in die ein Draht (D) des Drahtbündels (B) bei einer Drehung des Entnahmerades (11) aufgenommen wird und von der dieser Draht (D) mitgenommen wird,
**dadurch gekennzeichnet,**
- **dass** die Vorrichtung (V) Transporträder (12) aufweist, die koaxial und in axialer Richtung mit Abstand zu dem Entnahmerad (11) von einem Antrieb drehbar angeordnet sind, die je eine Kerbe zum Mitnehmen des Drahtes (D) aufweisen, der in der Mitnehmerkerbe des Entnahmerades aufgenommen ist und
- **dass** die Vorrichtung (V) Elemente (13) zum Verhindern der Aufnahme eines Drahtes (D) in die Mitnehmerkerben der Transporträder (12) aufweist, durch die verhindert wird, dass ein Draht des Drahtbündels (B) in die Mitnehmerkerbe der Transporträder (12) aufgenommen wird, der nicht in der Mitnehmerkerbe (112) des Entnahmerades (11) aufgenommen ist.

2. Entnahme- und Ausrichtvorrichtung (V) nach Anspruch 1, **dadurch gekennzeichnet, dass** das Entnahmerad (11) in der Mitte der Transporträder (12) angeordnet ist.

3. Entnahme- und Ausrichtvorrichtung (V) nach Anspruch 1 oder 2, **dadurch gekennzeichnet, dass** die Transporträder (12) mittels des gleichen Antriebes antreibbar sind wie das Entnahmerad (11).

4. Entnahme- und Ausrichtvorrichtung (V) nach einem der Ansprüche 1 bis 3, **dadurch gekennzeichnet, dass** das Entnahmerad (11) und die Transporträder (12) drehfest auf einer Welle (10) angeordnet sind.

5. Entnahme- und Ausrichtvorrichtung (V) nach einem der Ansprüche 1 bis 4, **dadurch gekennzeichnet, dass** die Transporträder (12) eine größere Anzahl von Mitnehmerkerben aufweisen als das Entnahmerad (11).

6. Entnahme- und Ausrichtvorrichtung (V) nach einem der Ansprüche 1 bis 5, **dadurch gekennzeichnet, dass** jedem der Transporträder (12) wenigstens eines der Elemente (13) zum Verhindern der Aufnahme eines Drahtes in die Mitnehmerkerben der Transporträder (12) zugeordnet ist.

7. Entnahme- und Ausrichtvorrichtung (V) nach Anspruch 6, **dadurch gekennzeichnet, dass** die Elemente (13) zum Verhindern
- von einer Drehachse der Transporträder (12) aus betrachtet in Richtung der Ablage über die Transporträder (12) und
- von der Ablage aus betrachtet über eine durch die Ablage definierte Ablageebene für das Drahtbündel (B)
hinausragen.

8. Entnahme- und Ausrichtvorrichtung (V) nach Anspruch 7, **dadurch gekennzeichnet, dass** die Elemente (13) zum Verhindern eine kreisbogenförmig gebogen Anlagefläche (131) oder Anlagekante aufweisen, wobei die Anlagefläche (131) oder Anlagekante jedes Elements (13) auf einem Kreis um die Drehachse des Transportrades (12) liegt, dem das Element (13) zugeordnet ist.

9. Entnahme- und Ausrichtvorrichtung (V) nach Anspruch 8, **dadurch gekennzeichnet, dass** ein Winkel zwischen der Ablageebene und einem oberen Ende der Anlagefläche oder Anlagekante jedes Elements (13) einstellbar ist.

10. Entnahme- und Ausrichtvorrichtung (V) nach Anspruch 9, **dadurch gekennzeichnet, dass** der Winkel zwischen der Ablageebene und dem oberen Ende der Anlagefläche oder Anlagekante für jedes Element (13) individuell oder gemeinsam für alle Elemente (13) einstellbar ist.

11. Entnahme- und Ausrichtvorrichtung (V) nach einem der Ansprüche 1 bis 10, **dadurch gekennzeichnet, dass** jedes der Elemente (13) zum Verhindern verschiebbar an einem Halter (14) befestigt ist, wodurch insbesondere der Winkel zwischen der Ablageebene und einem oberen Ende der Anlagefläche (131) oder Anlagekante jedes Elements (13) einstellbar ist.

12. Entnahme- und Ausrichtvorrichtung (V) nach einem der Ansprüche 1 bis 11, **dadurch gekennzeichnet, dass** die Führung (82, 91) wenigstens ein unteres Führungselement und wenigstens ein oberes Führungselement (9) aufweist, wobei wenigstens eines der oberen Führungselemente (9) und wenigstens eines der unteren Führungselemente einander zugeordnet sind und einen Spalt bilden, in den die aus dem Drahtbündel entnommenen Drähte mittels des Entnahmerades (11) und der Transporträder (12) gefördert werden kann.

13. Entnahme- und Ausrichtvorrichtung (V) nach Anspruch 12, **dadurch gekennzeichnet, dass** die Höhe des Spaltes einstellbar ist.

14. Entnahme- und Ausrichtvorrichtung (V) nach Anspruch 13, **dadurch gekennzeichnet, dass** zum Einstellen der Höhe des Spaltes das wenigstens eine obere Führungselement (9) verschiebbar gelagert ist.

15. Verfahren zum Entnehmen eines Drahts aus einem Drahtbündel (B) und zum Ausrichten des entnommenen Drahtes (D) mit einer Vorrichtung (V) nach einem der Ansprüche 1 bis 14, **dadurch gekennzeichnet, dass** mittels einer Mitnehmerkerbe (112) des sich drehenden Entnahmerades (11) ein Draht (D) aus dem Drahtbündel (B) erfasst und die erfasst Stelle des Drahtes (D) durch das Entnahmerad (11) mitgenommen und aus oder von dem Drahtbündel (B) entfernt wird, wobei der entnommene Draht (D) über die Anlagefläche (131) oder Anlagekante der Elemente (13) zum Verhindern der Aufnahme eines Drahtes in die Mitnehmerkerben der Transporträder (12) bis zu deren oberen Enden bewegt wird, bis dann der entnommene Draht (D) von den Mitnehmerkerben der Transporträder (12) erfasst und zu der Führung (82, 91) transportiert wird, an deren Beginn der entnommene Draht (D) aus den Mitnehmerkerben des Entnahmerades (11) und der Transporträder (12) herausgehoben und in die Führung (82, 91) bewegt wird.
